# DEMANDE DE BREVET EUROPEEN

(11) **EP 1 708 250 A2**
(43) Date de publication de la demande: **04.10.2006**
(21) Numéro de dépôt: 06111853.5
(22) Date de dépôt: 28.03.2006
(51) Int. Cl.: H01L 21/00

(54) **Identification d'un circuit intégré de référence pour équipement de prise et pose**

(30) Priorité: 29.03.2005 FR 0550793
(71) Demandeur: ST MICROELECTRONICS S.A., 92120 Montrouge (FR)
(72) Inventeur: Siaudeau, Jean-Louis, 13790 Rousset (FR)
(74) Mandataire: de Beaumont, Michel

(57) **Abrégé**

L'invention concerne un procédé et un système d'alignement d'un équipement de prise et pose de puces de circuits intégrés (IC), avec une origine d'une plaquette (P') portant ces circuits, consistant à rechercher optiquement sur la plaquette, au moins un motif de référence réalisé, lors de la fabrication des circuits intégrés, dans une puce de référence (RC), le motif de référence étant distinct de motif optiquement reconnaissables des autres puces.

## Description

### Domaine de l'invention

La présente invention concerne de façon générale les circuits électroniques et, plus particulièrement, les opérations de prélèvement automatique de circuits intégrés après découpe dans une plaquette, par des équipements dits de prise et pose (pick and place), pour montage sur un autre circuit ou en boîtier.

L'invention concerne plus précisément l'identification d'une puce de référence dans une plaquette de circuits intégrés pour initialiser un équipement de prise et pose automatique des puces après découpe.

### Exposé de l'art antérieur

La fabrication des circuits électroniques intégrés, qu'il s'agisse de composants passifs ou actifs, à partir de plaquettes semiconductrices ou isolantes, s'effectue généralement par lots de circuits, identiques ou non, sur une même plaquette. Une fois les circuits fabriqués, ils sont généralement testés, par exemple au moyen de cartes à pointes, de façon à détecter d'éventuels circuits défaillants. Ces circuits défaillants sont alors identifiés afin de ne pas être prélevés de la plaquette après découpe par l'équipement de prise et pose.

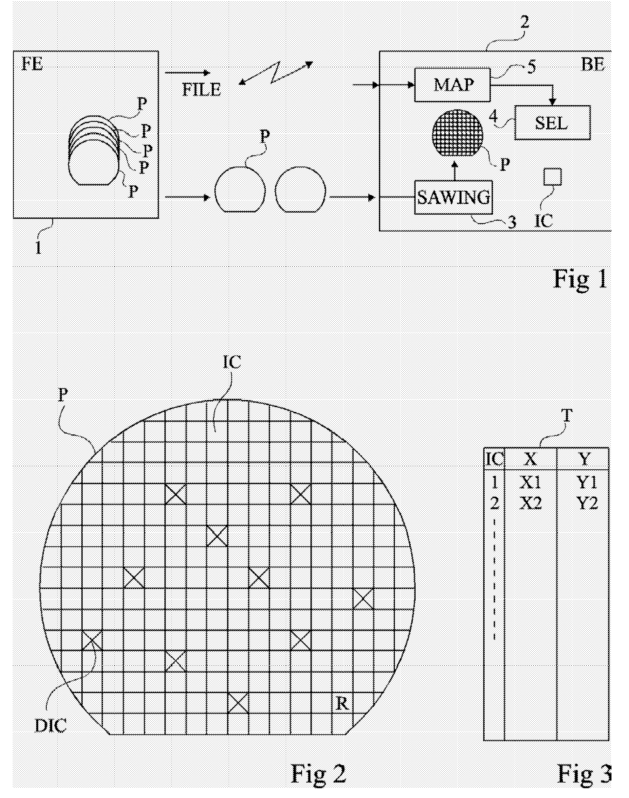

La figure 1 représente, de façon très schématique et sous forme de blocs, un exemple de système de fabrication de circuits intégrés IC à partir de plaquettes P, par exemple semiconductrices.

Le plus souvent, le traitement par lot pour fabriquer des circuits intégrés sur une même plaquette P s'effectue dans un premier lieu de fabrication 1 (symbolisé par un bloc FE, "Front End") dans lequel les circuits intégrés sont formés sur les plaquettes et sont testés.

Une première méthode connue pour identifier les circuits éventuellement défaillants consiste à déposer une goutte d'encre (encrer) sur ces circuits de façon à permettre leur reconnaissance ultérieure par des dispositifs optiques associés aux équipements de prise et pose.

Une deuxième technique connue à laquelle s'applique la présente invention consiste à enregistrer un fichier FILE contenant les coordonnées (généralement rectangulaires) des circuits défectueux (ou à l'inverse satisfaisants) dans la plaquette de façon à permettre leur repérage ultérieur.

Dans un tel cas, le fichier FILE contenant les coordonnées des plaquettes bonnes et/ou mauvaises est transmis parallèlement aux plaquettes P vers un autre lieu de fabrication (BE ou "Back End") symbolisé par un bloc 2, dans lequel les plaquettes sont découpées (bloc 3, SAWING) après avoir été le plus souvent rapportées sur un disque ou film support adhésif. Les plaquettes découpées P issues de cette étape sont alors traitées par un équipement de prise et pose (non représenté) pourvu d'éléments de sélection (bloc 4, SEL) des circuits intégrés IC corrects à partir d'une cartographie (bloc 5, MAP) dérivée du fichier de coordonnées FILE transmis. Les cartographies des différentes plaquettes testées sont stockées avec un identifiant de la plaquette, sous forme de fichiers numériques côté site de fabrication de plaquettes et côté site de montage, en transitant par exemple par un serveur central (non représenté).

Les figures 2 et 3 illustrent, respectivement, par une vue schématique de dessus d'une plaquette P de circuits intégrés et par une table T de coordonnées de circuits défaillants ou valables, le fonctionnement d'un équipement de prise et pose du type auquel s'applique la présente invention. Les coordonnées X et Y des différents circuits intégrés IC stockées dans la table T correspondent soit aux circuits IC valables de la figure 2 soit à des circuits intégrés défaillants DIC schématisés en figure 2 par des croix. Visuellement, ces circuits défaillants ne se différencient toutefois pas des circuits corrects dans la mesure où l'invention concerne un système sans marquage ("inkless").

Pour permettre un positionnement initial (alignement) de l'équipement de prise et pose par rapport à la plaquette, on choisit généralement une puce de référence (R, figure 2) que l'équipement de prise et pose va rechercher d'après les coordonnées du fichier, afin d'être en mesure par la suite de traiter les coordonnées contenues dans le fichier associé à la plaquette. Cette puce de référence permet de valider une position d'origine de la cartographie dans le référentiel de l'équipement.

Par exemple, un calcul approximatif du centre de la plaquette est exploité pour positionner l'équipement (plus précisément son détecteur visuel ou optique) sur la puce de référence R d'après les coordonnées lues dans le fichier. Puis, on cherche par itérations successives un endroit de la puce (souvent un coin) auquel correspondent les coordonnées. Une fois la position de la puce de référence connue dans le référentiel de l'équipement, le reste du fichier devient en principe interprétable. Les puces valables sont alors prélevées du disque adhésif support, généralement par un balayage ligne des puces de la plaquette, les puces défectueuses étant laissées sur le disque.

Des procédés et systèmes connus de ce type sont décrits, par exemple, dans les brevets américains N° 6 380 000 et 6 756 796.

Une telle solution est acceptable pour des puces de dimensions relativement importantes mais devient insatisfaisante avec une diminution de la taille des puces. En effet, la découpe de la plaquette engendre généralement une expansion de par la souplesse du film portant alors les différentes puces. Cette expansion ajoutée aux tolérances de positionnement engendre un risque que le positionnement approximatif sélectionne une puce de référence erronée (la puce voisine de la puce de référence). En cas d'erreur de ce type, l'exploitation du fichier de coordonnées devient fausse.

On a déjà proposé d'utiliser deux puces de référence à deux endroits différents de la plaquette pour corriger les éventuelles tolérances de positionnement.

Un inconvénient d'une telle solution est qu'en cas d'arrêt (par exemple accidentel) de l'équipement de prise et pose, il devient impossible de retrouver la référence lors du redémarrage si l'une de ces puces de référence a été prélevée pour montage.

On aurait pu penser enregistrer les coordonnées des puces de référence afin de les laisser sur le film porteur et ne pas les prélever pour montage. Un inconvénient est que l'on perd deux puces par plaquettes si les puces présentes aux positions de référence sont correctes. De plus, prélever ces puces en dernier nuit au rendement de l'équipement en imposant un retour en arrière par rapport au balayage. En outre, cela ne résout pas le problème pour le cas où plusieurs puces de taille ou de destination différentes sont portées par une même plaquette.

Les documents DE-A-102 19 346 et JP-A-63 136542 décrivent des procédés dans lesquels des puces sont marquées après fabrication.

Le document EP-A-1 424 723 décrit un procédé de marquage de puces par des motifs géométriques réalisés pendant la fabrication qui nécessite une étape post-fabrication pour les rendre reconnaissables optiquement.

### Résumé de l'invention

La présente invention vise à pallier tout ou partie des inconvénients des procédés et systèmes de montage de puces de circuits intégrés après découpe d'une plaquette.

L'invention vise plus particulièrement à résoudre les problèmes d'alignement d'une position d'origine sur une plaquette à traiter par rapport à l'équipement de prise et pose.

L'invention vise également à proposer une solution qui n'engendre pas la perte de puces valables.

L'invention vise également à proposer une solution compatible avec les étapes de fabrication par lot d'où sont issues les puces.

L'invention vise également à proposer une solution compatible avec les équipements de prise et pose classiques.

Pour atteindre tout ou partie de ces objets ainsi que d'autres, la présente invention prévoit un procédé d'alignement d'un équipement de prise et pose de puces de circuits intégrés, avec une origine d'une plaquette portant ces circuits, dans lequel au moins un motif de référence, réalisé lors de la fabrication des circuits intégrés dans une puce de référence, est recherché optiquement sur la plaquette, le motif de référence étant distinct de motifs optiquement reconnaissables des autres puces, et comportant des motifs géométriques reconnaissables optiquement dans le niveau de passivation ou dans le dernier niveau de métallisation de la plaquette.

Selon un mode de mise en oeuvre de la présente invention, plusieurs puces de référence sont réparties dans la plaquette.

L'invention prévoit également un système de montage de circuits intégrés au moyen d'un équipement de prise et pose à reconnaissance visuelle.

L'invention prévoit également une plaquette de circuits intégrés, comportant au moins une puce de référence comportant au moins un motif reconnaissable optiquement, distinct des motifs des autres puces réalisées dans la plaquette, et formé par le dernier niveau de métal de la plaquette ou par un masquage différent du niveau de passivation.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, qui a été décrite précédemment, représente de façon très schématique et sous forme de blocs, un système de fabrication de circuits intégrés du type auquel s'applique la présente invention ;
la figure 2, qui a été décrite précédemment, est une vue schématique de dessus d'une plaquette classique de circuits intégrés ;
la figure 3, qui a été décrite précédemment, illustre de façon très schématique la structure d'un fichier contenant les coordonnées de circuits intégrés défaillants ou valables ;
la figure 4 est une vue de dessus très schématique d'une plaquette de circuits intégrés selon un mode de réalisation de la présente invention ;
la figure 4A représente un détail agrandi de la figure 4, illustrant un exemple de motifs d'une puce de référence selon un mode de réalisation de l'invention ; et
la figure 5 illustre par une vue en coupe schématique un mode de réalisation d'un motif d'une puce de référence selon l'invention.

De mêmes éléments ont été désignés par de mêmes références aux différentes figures qui ont été tracées sans respect d'échelle. Par souci de clarté, seuls les étapes et éléments qui sont utiles à la compréhension de l'invention ont été représentés aux figures et seront décrits par la suite. En particulier, la fabrication des circuits intégrés passifs et/ou actifs sur une plaquette quelconque (semiconductrice, isolante, etc.) traitée par l'invention n'a pas été détaillée, l'invention étant compatible avec toutes les plaquettes classiques. De plus, l'équipement de prise et pose à partir d'une identification visuelle et par traitement d'un fichier de coordonnées n'a pas été détaillé, l'invention étant là encore compatible avec les équipements connus.

### Description détaillée

Une caractéristique d'un mode de réalisation de la présente invention est de prévoir, dans une plaquette portant des circuits intégrés, une ou plusieurs puces de référence comprenant des motifs compatibles avec une reconnaissance visuelle qui soient différents des motifs des circuits intégrés fabriqués sur la plaquette. De préférence, l'invention prévoit au moins deux puces de référence spécifiques ayant un ou plusieurs motifs reconnaissables par l'équipement de prise et pose.

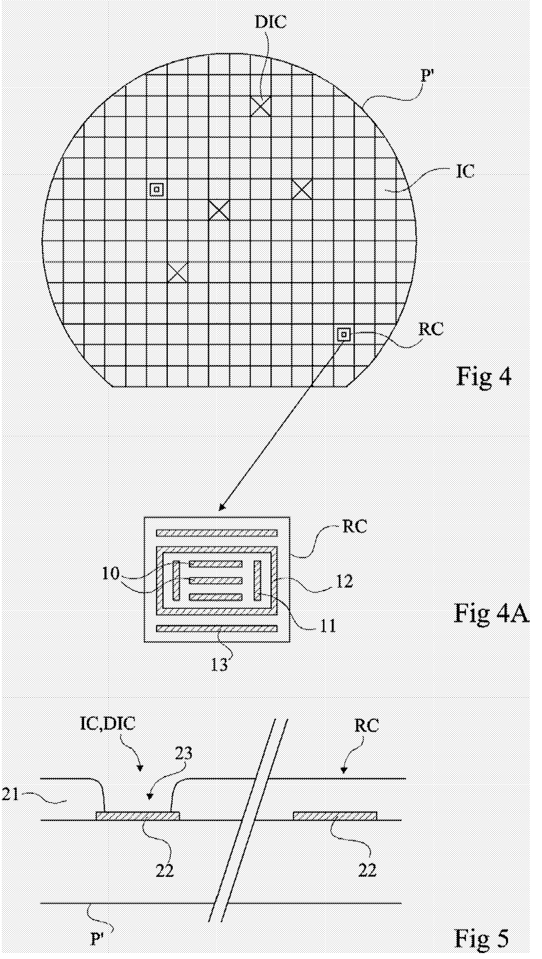

La figure 4 représente, par une vue de dessus très schématique, un mode de réalisation d'une plaquette P' selon l'invention. Comme précédemment, cette plaquette P' comporte des puces de circuits intégrés valides IC et défectueuses DIC. Selon ce mode de réalisation, deux puces de référence RC comportant des motifs particuliers, distincts des motifs reconnaissables visuellement des circuits IC, sont prévus dans la plaquette P'.

La figure 4A représente un agrandissement de la puce RC prise pour exemple en figure 4. Cette figure illustre différents motifs reconnaissables automatiquement visuellement par un équipement classique de prise et pose, tout en étant différents des motifs susceptibles de se trouver sur des circuits intégrés. Par exemple, on peut prévoir plusieurs motifs opaques 10 rectilignes et parallèles entre eux, encadrés par deux motifs opaques perpendiculaires 11. On pourra aussi prévoir, par exemple, un cadre 12 entourant les motifs 10 et 11, le cas échéant lui-même entouré par un ou plusieurs motifs rectilignes 13. Différentes combinaisons de motifs opaques sont envisageables pourvu que ces motifs soient individuellement et/ou dans leur combinaison identifiables par l'équipement de prise et pose comme différents de ceux d'une puce de circuit intégré IC. Le choix de tels motifs est à la portée de l'homme du métier à partir des indications fonctionnelles données dans la présente description.

Selon un mode de mise en oeuvre préféré de l'invention, les positions des puces de référence RC sont enregistrées dans un fichier (FILE, figure 1), en même temps qu'un numéro permettant d'identifier la plaquette P' et que la cartographie des puces valables ou défectueuses par leurs coordonnées respectives.

Une fois fabriquée et testée, la plaquette est transmise vers l'installation ou le site de découpe et montage (2, figure 1) de façon classique. De même, le fichier contenant la cartographie des puces de cette plaquette est transmis de façon classique à ce site généralement distant.

Côté installation de montage, les puces de référence sont recherchées par l'équipement de prise et pose en mettant en oeuvre des algorithmes similaires aux algorithmes de recherche classiques à partir du centre de la plaquette et de la position approximative enregistrée de ces puces de référence. Toutefois, il n'y a ici plus de risque de se baser sur une autre puce que la puce de référence. Pour le cas où le positionnement approximatif pointe sur une autre puce IC ou DIC, l'équipement détecte l'absence de motif de référence et entame une recherche en spirale autour de cette autre puce pour tomber sur la puce de référence.

Un avantage de l'invention est que les coordonnées enregistrées dans le fichier représentant la cartographie de la plaquette de circuits intégrés peuvent être exploitées de façon correcte quelle que soit la taille des puces.

Un autre avantage de la présente invention est qu'en cas d'arrêt en cours de traitement par l'équipement de prise et pose, il est possible de retrouver la référence dans la mesure où la ou les puces servant de référence sont restées sur le film adhésif.

Le fait d'utiliser préférentiellement plusieurs puces de référence permet de corriger une expansion non homogène du film portant les puces, par exemple, par le fait que des circuits intégrés de tailles différentes sont contenus sur une même plaquette.

Dans des applications où plusieurs types de puces sont contenus sur une même plaquette, deux puces de référence suffisent dans la mise en oeuvre de l'invention alors que dans un cas classique, la puce ayant servi de position de référence risque d'être perdue en étant montée avant que les puces de tailles différentes ne soient traitées.

Si la reconnaissance visuelle effectuée par l'équipement de prise et pose ne concerne qu'une partie de la puce de circuit intégré, le motif spécifique prévu par l'invention doit être différent de celui d'une puce correcte de cette zone examinée.

Selon un mode de réalisation préféré de l'invention, les motifs reconnaissables optiquement des puces de référence sont réalisés au moyen d'un masque de passivation spécifique. Le choix du masque de passivation est lié au fait qu'il s'agit généralement du masque le moins cher des différents masques utilisés pour la fabrication des circuits intégrés.

La figure 5 représente de façon très schématique et en coupe, un mode de réalisation d'un motif au moyen d'un tel masque de passivation. Par exemple, après réalisation des différents composants (non représentés) sur la plaquette P, la couche de passivation 21 est déposée pleine plaque sur le dernier niveau de métallisation dans lequel ont été formés, entre autres, des plots conducteurs 22 de raccordement des puces. De tels plots sont réalisés à la fois dans une zone correspondante aux puces de circuit intégré qu'elles soient valides IC ou défectueuses DIC et dans une zone correspondante de la puce de référence RC (masque identique). Pour simplifier, les autres pistes et niveaux des puces dans la plaquette P n'ont pas été représentés.

Au moyen d'un premier masque classique, on réalise des ouvertures 23 au droit des plots 22 pour reprendre les contacts des puces. Un deuxième masque spécifique est superposé lorsque les régions portant les puces RC sont exposées de façon à masquer complètement ces zones dans les puces de référence, permettant ainsi une différentiation optique entre les puces de référence RC et les puces normales IC.

Selon un mode de réalisation simplifié, un seul masque est utilisé avec un des motifs de puce qu'il comprend (généralement un même masque reproduit plusieurs puces) représentant la puce de référence spécifique. Ce mode de réalisation est toutefois réservé au cas où l'on peut se permettre de perdre une puce par exposition photolithographique.

Selon une autre variante de réalisation, les différentiations de motifs sont effectuées dans le dernier niveau de métallisation. Le masque de passivation utilisé reste alors identique pour toute la plaquette et la différentiation entre la puce de référence et les puces normales s'effectue grâce au niveau métallique.

Bien entendu, la présente invention est susceptible de diverses variantes et modifications qui apparaîtront à l'homme de l'art. En particulier, la mise en oeuvre pratique de l'invention à partir des indications fonctionnelles données ci-dessus est à la portée de l'homme du métier. De plus, bien que l'invention ait été décrite en relation avec un exemple de motifs géométriques rectilignes, n'importe quel type de motif pourra être envisagé pourvu qu'il s'agisse d'un motif ou d'une combinaison de motifs non susceptible d'être reproduit sur une puce valide. Le choix de ces motifs est préférentiellement fait pour être compatible avec plusieurs gammes de circuits intégrés. En variante, plusieurs types de motifs de référence pourront être utilisés selon les types de plaquettes fabriquées. Dans ce cas, les motifs sont, par exemple, transmis sous forme de fichier numérique au site de montage en même temps que le fichier contenant les coordonnées des puces.

## Revendications

1. Procédé d'alignement d'un équipement de prise et pose de puces de circuits intégrés (IC), avec une origine d'une plaquette (P') portant ces circuits, dans lequel au moins un motif de référence, réalisé lors de la fabrication des circuits intégrés dans une puce de référence (RC), est recherché optiquement sur la plaquette, le motif de référence étant distinct de motifs optiquement reconnaissables des autres puces, **caractérisé en ce que** la puce de référence (RC) comporte des motifs géométriques (10, 11, 12, 13) reconnaissables optiquement dans le niveau de passivation ou dans le dernier niveau de métallisation de la plaquette.

2. Procédé selon la revendication 1, dans lequel plusieurs puces de référence (RC) sont réparties dans la plaquette (P').

3. Système de montage de circuits intégrés (IC) au moyen d'un équipement de prise et pose à reconnaissance visuelle, **caractérisé en ce qu'**il comporte des moyens pour la mise en oeuvre du procédé selon la revendication 1.

4. Plaquette (P') de circuits intégrés (IC), **caractérisée en ce qu'**elle comporte au moins une puce (RC) de référence comportant, dans le niveau de passivation ou dans le dernier niveau de métallisation, au moins un motif (10, 11, 12, 13) reconnaissable optiquement, distinct des motifs des autres puces (IC) réalisées dans la plaquette.
